# EUROPÄISCHE PATENTSCHRIFT

(11) **EP 1 421 618 B1**
(45) Veröffentlichungstag und Bekanntmachung des Hinweises auf die Patenterteilung: **01.06.2005**
(21) Anmeldenummer: 02798678.5
(22) Anmeldetag: 29.08.2002
(51) Int. Cl.: H01L 23/373

(54) **LEISTUNGSELEKTRONIKEINHEIT**
POWER ELECTRONICS COMPONENT
UNITE ELECTRONIQUE DE PUISSANCE

(30) Priorität: 31.08.2001 DE 10142615
(43) Veröffentlichungstag der Anmeldung: 26.05.2004
(73) Patentinhaber: SIEMENS AKTIENGESELLSCHAFT, 80333 München (DE)
(72) Erfinder: LUCKE, Olaf, 60598 Frankfurt/Main (DE); THYZEL, Bernd, 61479 Schlossborn (DE)
(86) Internationale Anmeldenummer: PCT/DE2002/003178
(87) Internationale Veröffentlichungsnummer: WO 2003/026009

(56) Entgegenhaltungen:
- EP-A- 1 089 334
- DE-A- 3 837 975
- DE-A- 4 318 061
- PATENT ABSTRACTS OF JAPAN vol. 1996, no. 07, 31. Juli 1996 (1996-07-31) & JP 08 083867 A (MITSUBISHI MATERIALS CORP), 26. März 1996 (1996-03-26)
- PATENT ABSTRACTS OF JAPAN vol. 1999, no. 13, 30. November 1999 (1999-11-30) & JP 11 236278 A (NGK INSULATORS LTD), 31. August 1999 (1999-08-31)

## Beschreibung

Die Erfindung bezieht sich auf eine Leistungselektronikeinheit, insbesondere für ein Steuergerät in einem Kraftfahrzeug, mit einem flächigen Keramiksubstrat, auf dessen einer Seite in Dickschichttechnik Leiterbahnen zur elektrischen Verbindung von ebenfalls auf dem Keramiksubstrat befindlichen elektrischen Leistungsbauelementen einer Schaltung angeordnet sind und das mit seiner anderen Seite mittels Hartlöten auf einem als Wärmespreizer dienenden metallischen Trägerelement aufgebracht ist, wobei das Trägerelement wärmeleitend mit einem wärmeleitenden Gehäusebauteil eines das Trägerelement aufnehmenden Gehäuses verbunden ist.

DE-A-4 318 061 offenbart eine Leistungselektronikeinheit mit einem flächigen Keramiksubstrat auf dessen einen Seite Leiterbahnen aus Kupfer zur elektrischen Verbindung von einem auf dem Keramiksubstrat befindlichen Leistungsbauelement angeordnet sind und das mit seiner anderen Seite mittels Erhitzen auf einer mit Leiterbahnen strukturierten Kupferschicht, die implizit als Wärmespreizer dient, aufgebracht ist. Auf der dem Keramiksubstrat abgewandten Seite der Kupferschicht ist gegenüberliegend ein zweites Keramiksubstrat gleicher Abmessung wie das die Schaltung tragende Keramiksubstrat aufgebracht.

Bei Leistungselektronikeinheiten besteht das Problem, daß die elektrischen Leistungsbauelemente Wärme erzeugen, die abgeführt werden muß. Dazu ist es bekannt das Trägerelement als flächiges Keramiksubstrat auszubilden, auf dem in Dickschichttechnik Leiterbahnen aufgebracht sind und die elektrischen Leistungsbauelemente sowie ggf. auch Steuerbauelemente durch Weichlöten mit den Leiterbahnen verbunden sind. Durch Hartlöten ist das Keramiksubstrat auf ein metallisches Trägerelement aufgebracht, das als Wärmespreizer dient und mittels eines Klebers mit einem wärmeleitenden Gehäusebauteil verbunden wird.

Aufgrund der unterschiedlichen Ausdehnungskoeffizienten des Trägerelements und des Keramiksubstrats kommt es zu unterschiedliche starken Verformungen dieser Bauteile, was beim Abkühlen nach dem Hartlöten zu Beschädigungen des Keramiksubstrats und ggf. später auch zu Beschädigungen der Weichlotverbindungen zwischen den Leiterbahnen und den elektrischen Leistungsbauelementen führen kann.

Aufgabe der Erfindung ist es daher eine Leistungselektronikeinheit der eingangs genannten Art zu schaffen, die eine gute Wärmeabfuhr der von den elektrischen Leistungsbauelementen erzeugten Wärme gewährleistet und bei der durch die unterschiedlichen Ausdehnungskoeffizienten der Materialien von Keramiksubstrat und Trägerelement bedingte Beschädigungen vermieden werden.

Diese Aufgabe wird durch die Kombination der Merkmale von Anspruch 1 gelöst, wobei auf der dem Keramiksubstrat abgewandten Seite des Trägerelements diesem Keramiksubstrat etwa gegenüberliegend ein zweites Keramiksubstrat etwa gleicher Abmessung wie das die Schaltung tragende Keramiksubstrat mittels Hartlöten aufgebracht ist.

Durch das Hartlöten von etwa gleichen Keramiksubstraten auf beiden Seiten des Trägerelements entstehen von beiden Seiten des Trägerelements her etwa gleiche, aber entgegengesetzt wirkende Wärmespannungen, die sich zumindest weitgehend kompensieren und so eine wärmespannungsbedingte Beschädigung des die Schaltung tragenden Keramiksubstrats vermeiden. Dabei erfolgt das Hartlöten der beiden Keramiksubstrate möglichst ohne ein dazwischen liegendes Abkühlen.

Durch die erfindungsgemäße Ausbildung erfolgt weiterhin eine sehr gute Ableitung der von den elektrischen Leistungsbauelementen erzeugten Wärme, da diese über die Hartlotverbindung von dem Keramiksubstrat sehr gut auf das gut wärmeleitende und als Wärmespreizer dienende Trägerelement übertragen und dort auf eine größere Fläche verteilt wird, ehe die weitere Wärmeabfuhr zum Gehäusebauteil und zur Umgebung erfolgt. Eine Reduzierung der Wärmeabfuhr durch eine Klebeverbindung zum Gehäusebauteil wird vermieden.

Das Trägerelement kann aus Aluminium bestehen, wobei die Ausbildung aus Reinaluminium aufgrund dessen höherer Wärmeleitfähigkeit die Wärmeabfuhr noch verbessert.

Weisen dabei beide Keramiksubstrate auf ihrer hartzulötenden Fläche eine Dickschichtmaterialschicht auf, deren freie Oberflächen vernickelt sind, so beeinträchtigen die hohen Temperaturen der Hartlötprozesse nicht das einen relativ niedrigen Schmelzpunkt aufweisende Trägerelement aus Aluminium.

Zu einer noch günstigeren Wärmeabfuhr und damit Wärmespreizung führt es, wenn das Trägerelement aus Kupfer besteht, das eine sehr hohe Wärmeleitfähigkeit besitzt.

Eine oder beide Keramiksubstrate können aus Al₂O₃ bestehen.

Um einen optimalen Wärmeübergang von dem Keramiksubstrat zum Trägerelement zu erhalten, können die Keramiksubstrate über zumindest weitgehend ihre gesamten Flächen mit dem Trägerelement durch Hartlöten verbunden sein.

Sowohl eine einfache als auch gut wärmeleitende Verbindung wird dadurch erreicht, daß das Trägerelement eine größere Flächenerstreckung als die Keramiksubstrate aufweist und mit seinen über die Keramiksubstrate herausragenden Bereichen ganz oder teilweise flächig an dem Gehäusebauteil anliegend mit diesem verbunden ist

Um auch die Fläche des zweiten Keramiksubstrats zur Ableitung der Wärme der elektrischen Leistungsbauelemente zu nutzen, kann das zweite Keramiksubstrat mit seiner dem Trägerelement abgewandten Seite flächig an dem Gehäusebauteil in Anlage sein.

Zur leichten Montage des beidseitig ein Keramiksubstrat tragenden Trägerelements kann das zweite Keramiksubstrat in eine etwa seinen Abmessungen entsprechende Ausnehmung des Gehäusebauteils ragen.

Der Wärmeübergang von dem zweiten Keramiksubstrat auf das Gehäusebauteil wird noch weiter verbessert, wenn zwischen dem zweiten Keramiksubstrat und dem Gehäusebauteil eine Schicht Wärmeleitpaste angeordnet ist.
Eine sowohl sichere als auch einfach durchzuführende Anordnung des Trägerelements am Gehäusebauteil wird dadurch erreicht, daß das Trägerelement mittels Befestigungselementen an dem Gehäusebauteil angeordnet ist, wobei in einfacher Weise das Trägerelement mittels Schrauben an dem Gehäusebauteil befestigt sein kann.

Zusätzlich kann zwischen Trägerelement und Gehäusebauteil eine Schicht Wärmeleitpaste angeordnet werden, die den Wärmeübergang von dem Trägerelement zum Gehäusebauteil noch verbessert.

Um eine besonders gute Wärmeabfuhr an die Umgebung zu erreichen, kann das Gehäusebauteil eine Außenwand des Gehäuses sein.

Ist die von den elektrischen Leistungsbauelementen erzeugte und abzuführende Wärme besonders hoch, so kann das Gehäusebauteil eine von einem Kühlmittel beaufschlagte Wand des Gehäuses sein.

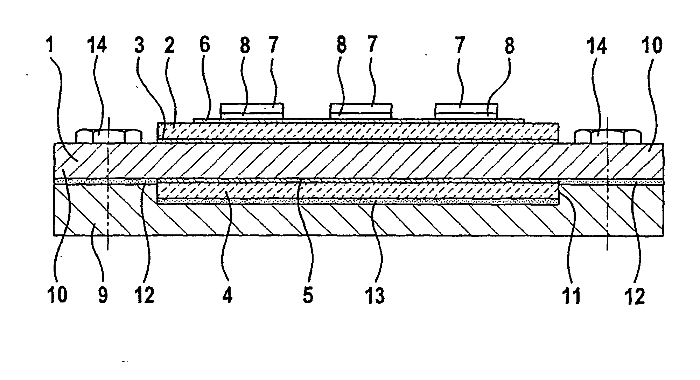

Ein Ausführungsbeispiel der Erfindung ist in der Zeichnung dargestellt und wird im folgenden näher beschrieben. Die einzige Figur der Zeichnung zeigt einen Querschnitt einer Leistungselektronikeinheit.

Die dargestellte Leistungselektronikeinheit weist ein rechteckiges Trägerelement 1 aus Reinaluminium auf, auf dessen Oberseite ein erstes flächiges Keramiksubstrat 2 über seine gesamte Fläche mittels einer Hartlotschicht 3 aufgelötet ist.

Auf der Unterseite des Trägerelements 1, dem Keramiksubstrat 2 gegenüberliegend und die gleichen Abmessungen aufweisend, ist ein zweites Keramiksubstrat 4 ebenfalls mittels einer Hartlotschicht 5 aufgelötet.

Nach diesen beiden Hartlotvorgängen, die ohne ein dazwischen liegendes Abkühlen durchgeführt wurden, wurden in Dickschichttechnik Leiterbahnen 6 auf dem Keramiksubstrat 2 aufgebracht, die zur elektrischen Verbindung von elektrischen Leistungsbauelementen 7, in diesem Fall von Transistoren, dienen und mit diesen eine Schaltung bilden. Die elektrischen Leistungsbauelemente 7 sind mittels Weichlot 8 mit der Leiterbahn 6 leitend verbunden und damit auf dem Keramiksubstrat 2 befestigt.

Diese Baueinheit ist derartig mit einem Gehäusebauteil 9 eines aus Aluminiumdruckguß bestehenden Gehäuses verbunden, daß das eine größere Flächenerstreckung aufweisende Trägerelement 1 als die Keramiksubstrate 2 und 4 mit seinem über die Keramiksubstrate 2 und 4 herausragenden Bereichen 10 flächig an dem Gehäusebauteil 9 anliegt.

In dem Gehäusebauteil 9 ist eine Ausnehmung 11 ausgebildet, die etwa der Abmessung des zweiten Keramiksubstrats 4 entspricht und in die das zweite Keramiksubstrat 4 hineinragt.

Zwischen den über die Keramiksubstrate 2 und 4 herausragenden Bereichen 10 und dem Gehäusebauteil 9 ist eine Schicht Wärmeleitpaste 12 und zwischen dem zweiten Keramiksubstrat 4 und dem Boden der Ausnehmung 1 eine weitere Schicht Wärmleitpaste 13 angeordnet.

In den Bereichen 10 ist das Trägerelement 1 mittels Schrauben 14 mit dem Gehäusebauteil 9 fest verbunden.

## Patentansprüche

1. Leistungselektronikeinheit, insbesondere für ein Steuergerät in einem Kraftfahrzeug, mit einem flächigen Keramiksubstrat, auf dessen einer Seite in Dickschichttechnik Leiterbahnen zur elektrischen Verbindung von ebenfalls auf dem Keramiksubstrat befindlichen elektrischen Leistungsbauelementen einer Schaltung angeordnet sind und das mit seiner anderen Seite mittels Hartlöten auf einem als Wärmespreizer dienenden metallischen Trägerelement aufgebracht ist, wobei das Trägerelement wärmeleitend mit einem wärmeleitenden Gehäusebauteil eines das Trägerelement aufnehmenden Gehäuses verbunden ist, wobei auf der dem Keramiksubstrat (2) abgewandten Seite des Trägerelements (1) diesem Keramiksubstrat (2) etwa gegenüberliegend ein zweites Keramiksubstrat (4) etwa gleicher Abmessung wie das die Schaltung tragende Keramiksubstrat (2) mittels Hartlöten aufgebracht ist.

2. Leistungselektronikeinheit nach Anspruch 1, **dadurch gekennzeichnet, daß** das Trägerelement (1) aus Aluminium, insbesondere aus Reinaluminium besteht.

3. Leistungseleektronikeinheit nach Anspruch 2, **dadurch gekennzeichnet, daß** beide Keramiksubstrate auf ihrer hartzulötenden Fläche eine Dickschichtmaterialschicht aufweisen, deren freie Oberflächen vernickelt sind.

4. Leistungselektronikeinheit nach Anspruch 1, **dadurch gekennzeichnet, daß** das Trägerelement aus Kupfer besteht.

5. Leistungselektronikeinheit nach einem der vorhergehenden Ansprüche, **dadurch gekennzeichnet, daß** ein oder beide Keramiksubstrate (2, 4) aus Al₂O₃ bestehen.

6. Leistungselektronikeinheit nach einem der vorhergehenden Ansprüche, **dadurch gekennzeichnet, daß** die Keramiksubstrate (2, 4) über zumindest weitgehend ihre gesamte Fläche mit dem Trägerelement (1) durch Hartlöten verbunden sind.

7. Leistungselektronikeinheit nach einem der vorhergehenden Ansprüche, **dadurch gekennzeichnet, daß** das Trägerelement (1) eine größere Flächenerstreckung als die Keramiksubstrate (2, 4) aufweist und mit seinen über die Keramiksubstrate (2, 4) herausragenden Bereichen (10) ganz oder teilweise flächig an dem Gehäusebauteil (9) anliegend mit diesem verbunden ist.

8. Leistungselektronikeinheit nach einem der vorhergehenden Ansprüche, **dadurch gekennzeichnet, daß** das zweite Keramiksubstrat (4) mit seiner dem Trägerelement (1) abgewandten Seite flächig an dem Gehäusebauteil (9) in Anlage ist.

9. Leistungselektronikeinheit nach einem der vorhergehenden Ansprüche, **dadurch gekennzeichnet, daß** das zweite Keramiksubstrat (4) in eine etwa seinen Abmessungen entsprechende Ausnehmung (11) des Gehäusebauteils (9) ragt.

10. Leistungselektronikeinheit nach einem der vorhergehenden Ansprüche, **dadurch gekennzeichnet, daß** zwischen dem zweiten Keramiksubstrat (4) und dem Gehäusebauteil (9) eine Schicht Wärmeleitpaste (13) angeordnet ist.

11. Leistungselektronik nach einem der vorhergehenden Ansprüche, **dadurch gekennzeichnet, daß** das Trägerelement (1) mittels Befestigungselementen an dem Gehäusebauteil (9) angeordnet ist.

12. Leistungselektronikeinheit nach Anspruch 11, **dadurch gekennzeichnet, daß** das Trägerelement (1) mittels Schrauben (14) an dem Gehäusebauteil (9) befestigt ist.

13. Leistungselektronikeinheit nach einem der vorhergehenden Ansprüche, **dadurch gekennzeichnet, daß** zwischen Trägerelement (1) und Gehäusebauteil (9) eine Schicht Wärmeleitpaste (12) angeordnet ist.

14. Leistungselektronikeinheit nach einem der vorhergehenden Ansprüche, **dadurch gekennzeichnet, daß** das Gehäusebauteil (9) eine Außenwand des Gehäuses ist.

15. Leistungselektronikeinheit nach einem der Ansprüche 1 bis 10, **dadurch gekennzeichnet, daß** das Gehäusebauteil eine von einem Kühlmittel beaufschlagte Wand des Gehäuses ist.

## Claims

1. Power electronics unit, in particular for a control device in a motor vehicle, with a planar ceramic substrate, on one side of which conductor tracks are provided using the thick-film technique for electrically connecting electrical power components of a circuit that are likewise arranged on the ceramic substrate and which is brazed by its other side onto a metal support element serving as a heat spreader, the support element being connected in a thermally conducting manner to a thermally conducting housing component of a housing accommodating the support element, a second ceramic substrate (4) of approximately the same dimensions as the ceramic substrate (2) bearing the circuit being brazed onto the side of the support element (1) that is facing away from the ceramic substrate (2), approximately opposite from the said ceramic substrate (2).

2. Power electronics unit according to Claim 1, **characterized in that** the support element (1) consists of aluminium, in particular of pure aluminium.

3. Power electronics unit according to Claim 2, **characterized in that** both ceramic substrates have a layer of thick-film material on their surface area that is to be brazed, with nickel plating on the free surfaces of the said layer.

4. Power electronics unit according to Claim 1, **characterized in that** the support element consists of copper.

5. Power electronics unit according to one of the preceding claims, **characterized in that** one or both ceramic substrates (2, 4) consists of Al₂O₃.

6. Power electronics unit according to one of the preceding claims, **characterized in that** the ceramic substrates (2, 4) are connected to the support element (1) by brazing over their entire surface area, at least to a great extent.

7. Power electronics unit according to one of the preceding claims, **characterized in that** the support element (1) has a greater surface area extent than the ceramic substrates (2, 4) and is connected to the housing component (9) by its regions (10) that protrude beyond the ceramic substrates (2, 4) resting entirely or partly flat against it.

8. Power electronics unit according to one of the preceding claims, **characterized in that** the second ceramic substrate (4) is in contact with the housing component (9) by its side that is facing away from the support element (1) resting flat against it.

9. Power electronics unit according to one of the preceding claims, **characterized in that** the second ceramic substrate (4) protrudes into a recess (11) of the housing component (9) corresponding approximately to its dimensions.

10. Power electronics unit according to one of the preceding claims, **characterized in that** a layer of thermally conductive paste (13) is arranged between the second ceramic substrate (4) and the housing component (9).

11. Power electronics according to one of the preceding claims, **characterized in that** the support element (1) is arranged on the housing component (9) by means of fastening elements.

12. Power electronics unit according to Claim 11, **characterized in that** the support element (1) is fastened on the housing component (9) by means of screws (14).

13. Power electronics unit according to one of the preceding claims, **characterized in that** a layer of thermally conductive paste (12) is arranged between the support element (1) and the housing component (9).

14. Power electronics unit according to one of the preceding claims, **characterized in that** the housing component (9) is an outer wall of the housing.

15. Power electronics unit according to one of Claims 1 to 10, **characterized in that** the housing component is a wall of the housing that is subjected to a cooling agent.

## Revendications

1. Unité électronique de puissance, prévue notamment pour un appareil de commande dans un véhicule automobile, comportant un substrat plan en céramique sur une face duquel sont disposées, en technique des couches épaisses, des pistes conductrices destinées au raccordement électrique de composants électriques de puissance d'un circuit se trouvant également sur le substrat e n céramique e t dont l'autre f ace e st f ixée p ar brasage fort s ur un élément porteur en métal servant de dissipateur thermique, l'élément porteur étant relié d'une façon conduisant la chaleur à une partie à conduction thermique d'un boîtier destiné à recevoir l'élément porteur, alors que, sur la face de l'élément porteur (1) opposée au substrat en céramique (2), environ en face de ce substrat en céramique (2), un deuxième substrat en céramique (4), ayant approximativement les mêmes dimensions que le substrat en céramique (2) portant le circuit, est fixé au moyen d'un brasage fort.

2. Unité électronique de puissance selon la revendication 1 **caractérisé par le fait que** l'élément porteur (1 ) est en aluminium, notamment en aluminium pur.

3. Unité électronique de puissance selon la revendication 2 **caractérisé par le fait que** les deux substrats en céramique ont, sur leur surface à braser, une couche de matière appliquée en couche épaisse, dont les surfaces extérieures libres sont nickelées.

4. Unité électronique de puissance selon la revendication 1 **caractérisé par le fait que** l'élément porteur est en cuivre.

5. Unité électronique de puissance selon l'une des revendications précédentes **caractérisé par le fait que** l'un des substrats en céramique ou les deux (2, 4) sont en Al₂O₃.

6. Unité électronique de puissance selon l'une des revendications précédentes **caractérisé par le fait que** les substrats en céramique (2, 4) sont liés par brasage fort à l'élément porteur (1) sur au moins une grande partie de leur surface totale.

7. Unité électronique de puissance selon l'une des revendications précédentes **caractérisé par le fait que** l'élément porteur (1) a une surface plus importante que les substrats en céramique (2, 4) et qu'il est lié, par ses zones (10) dépassant des substrats en céramique (2, 4), en s'appliquant en totalité ou en partie en nappe sur la pièce (9) du boîtier, à cette dernière.

8. Unité é lectronique de puissance selon l'une des revendications précédentes **caractérisé par le fait que** le deuxième substrat en céramique (4) s'applique en nappe sur la pièce (9) du boîtier par sa face opposée à l'élément porteur (1).

9. Unité électronique de puissance selon l'une des revendications précédentes **caractérisé par le fait que** le deuxième substrat e n céramique (4) fait saillie dans un évidement (11 ) de la pièce (9) du boîtier correspondant à peu près à ses dimensions.

10. Unité é lectronique de puissance selon l'une des revendications précédentes **caractérisé par le fait que**, entre le deuxième substrat en céramique (4) et la pièce (9) du boîtier, est disposée une couche de pâte (13) à conduction thermique.

11. Unité électronique de puissance selon l'une des revendications précédentes **caractérisé par le fait que** l'élément porteur (1) est fixé sur la pièce (9) du boîtier au moyen d'éléments de fixation.

12. Unité électronique de puissance selon la revendication 11 **caractérisé par le fait que** l'élément porteur (1 ) est fixé sur la pièce (9) du boîtier au moyen de vis (14).

13. Unité é lectronique de puissance selon l'une des revendications précédentes **caractérisé par le fait que**, entre l'élément porteur (1) et la pièce (9) du boîtier, est disposée une couche de pâte (12) à conduction thermique.

14. Unité électronique de puissance selon l'une des revendications précédentes **caractérisé par le fait que** la pièce (9) du boîtier est une paroi extérieure du boîtier.

15. Unité électronique de puissance selon l'une des revendications 1 à 10 **caractérisé par le fait que** la pièce du boîtier est une paroi du boîtier soumise à un produit réfrigérant.
